# EUROPEAN PATENT SPECIFICATION

(11) **EP 2 302 455 B1**
(45) Date of publication and mention of the grant of the patent: **09.05.2012**
(21) Application number: 10382251.6
(22) Date of filing: 20.09.2010
(51) Int. Cl.: G03F 7/00

(54) **Plate cutting apparatus**
Plattenschneidvorrichtung
Appareil de découpe de plaques

(30) Priority: 23.09.2009 ES 200901350 U
(43) Date of publication of application: 30.03.2011
(73) Proprietor: Moliner Verdaguer, Mª Teresa, 08206 Sabadell (ES)
(72) Inventor: Moliner Verdaguer, Mª Teresa, 08206 Sabadell (ES)
(74) Representative: Curell Suñol, Marcelino

(56) References cited:
- EP-A1- 0 606 662
- EP-A2- 0 586 821
- EP-A2- 0 820 840
- DE-A1- 4 024 615
- FR-A1- 2 292 559
- FR-A1- 2 528 348
- GB-A- 899 348
- US-A1- 2001 000 463
- US-A1- 2005 226 671

## Description

### Object of the invention

The present invention relates, as indicated in the title thereof, to a plate cutting apparatus, more particularly a photopolymer plate cutting apparatus belonging to the type of cutting devices for sheet-like articles which, working according to the scissors principle, are provided with a stationary, horizontal rectilinear blade acting as an counter blade for a moving disc blade, of which the disc blade is rotatable around a stub axle fixed to a carriage which is moveable on a horizontal rail, said disc blade engaging with the plane of its cutting edge against the plane of the stationary blade acting as a counter blade, both being contained in one same vertical plane which is perpendicular to the flat surface of the sheet to be cut.

### Background of the invention

Cutting apparatus are known for cutting sheet-like articles, such as technical drawings, paper board, non-woven fabrics and others used in various professional activities. In all of them the plane containing the cutting edges of the disc blade and rectilinear counter blade is comprised in one same vertical plane which is perpendicular to the working plane of the material to be cut, which is normally horizontal.

Some of said apparatus are described in U.S. patents 2,327,223 and 5,069,097, GB patent 856,192 and ES 2 112 478, as well as in GB-A-899 348, EP-A-606662, FR-A- 2292559 and US-A-2005/226671.

When cutting paper, paper board, non-wovens, plastic sheets and other similar items, the thickness of the material is so small that the fact that the right section of the cut is a right angle, an acute angle or an obtuse angle is immaterial, since the articles obtained do not have to place the cut edges in abutting contact.

However, in the case of photopolymer plate sheets, these are known to have an appreciable thickness and that in their use in cylindrical form on a printing roll, the faces of two opposite end edges must coincide like a generatrix of the cylinder so that, when printing on a surface using the roll incorporating the said plate sheet, no printing irregularity appears due to the fact that the joint between the said faces is deformed owing to a deficient cut, as is the one made by hand with scissors, a ruler and cutter or other imprecise means.

The lack of absolute coincidence in the abutment of the surfaces of the opposed edges of the plate when placing it on the printing roll determines the creation of open spaces which, when becoming filled with ink in the inking of the plate, cause blots on the printed material, or form elevated regions to which an excess amount of ink adheres during the inking, giving rise to blots in the printing operation.

Nevertheless, when the plate has been cut perfectly, giving regular orthogonal right section end edges fully mating together over their whole surface, the drawback arises that that a small amount of air may remain between the surface of the printing roll and the rear surface of the plate which, when adhering it to the roll, cause the lifting or unsticking of the opposed ends of the plate.

With a view to obviating these drawbacks, the solution has been adopted of using an apparatus of the known type of those which work on the scissors principle and which comprise a circular cutting member, as a rotating blade, which moves along a rectilinear anvil member acting as a counter blade, with the novelty that the cut is made on an inclined plane, whereby the cut end edges of the plate take on the configuration of a single bevel.

In accordance with the foregoing solution, a plate cutting apparatus has been developed which is the object of the invention and which is formed by the association of a moving cutting member having a disc blade which is slidable along a rail and a stationary rectilinear counter blade member which is parallel to said rail, which are disposed permanently with partial successive mutual surfaces in sliding contact, which surfaces are contained in a common plane sloping at an acute angle relative to the plane of the support surface for the plate sheet to be cut at the ends thereof, determining the value of the dihedral angle resulting from the single bevel cut made at the ends of the plate sheet by the relative movement of both members. The invention is defined in the claims.

One feature of the invention is that the two opposite cut end sides of the plate sheet are cut as single bevels such that, having been made in opposite directions, after installation of the plate on the roll of a printing machine, said ends contact each other along the apexes of the acute dihedral angles of their single bevels, forming an isosceles triangular section hollow space having an externally concave base.

A further feature of the invention is that the disc blade of the moving cutting member is formed by a rotating disc having a single bevel perimetrical cutting edge, which is moveable in a straight line such that the active face of the faces thereof is contained in a virtual plane in which the active face of a stationary counter blade member is also contained, with the latter being formed by a rule contained on one face of an acute dihedral angle facing away from the plane of the support surface of the plate sheet to be cut.

Yet a further feature of the invention is that the moving cutting member having a disc blade is formed by a rotating disc mounted on a sliding carriage which, in turn, is rockingly mounted on a rail and is moveable therealong, such that the active face of the rotating disc, forming the moving cutting member, is held engaged by gravity against the active face of the stationary counter blade member.

Yet another feature of the invention is that the moving cutting member having a disc blade is rotatably mounted on a carriage which is slidingly non-rotatably mounted on a rail and is moveable therealong, such that the active face of the rotating disc, forming the moving cutting member, is held engaged firmly against the active face of the stationary counter blade member.

Further features of the invention arise from the following facts:
a.- The ends of the stationary counter blade member and of the rail are associated with respective fixed support bodies therefor fixedly attached to a support base for the plate sheet.
b.- The two support bodies for the stationary counter blade member and for the rail form the ends of a support body in which the ends of said counter blade and rail are engaged, at the same time as it supports the counter blade over the entire length thereof and keeps the rail suspended with freedom of movement for the sliding carriage.
c.- The rotating disc of the moving cutting member having a disc blade is associated with a resilient pressure member pressing against the plate sheet and accompanying the rotating disc along the stroke thereof.
d.- The moving cutting member having a disc blade mounted on the moveable carriage is housed in a protective casing, which may be provided with a handle.

### Brief Description of the Drawings

To facilitate an understanding of the above ideas, and disclose at the same time various details of a constructional nature, there is described hereinafter one embodiment of the present invention with reference to the drawings accompanying this specification, which drawings, in view of their primarily illustrative nature, must be construed as being devoid of any limiting scope relative to the breadth of legal protection applied for. In the drawings:
Figure 1 is a schematic view of an assembly which, according to the invention, is formed by the association of a moving cutting member having a disc blade applied against a stationary rectilinear counter blade member, in a position of being able to carry out a cutting operation.
Figure 2 is a schematic view of the assembly of the previous Figure after a sheet of photopolymer sheet has been cut.
Figure 3 is a schematic view of the meeting portion, in a state of having been mounted on the printing roll, of the edges of both end sides of a plate sheet as a result of the single bevel cuts made according to the invention.
Figure 4 is a schematic cross section view of the disc blade carrier carriage and of the support and travel rail therefor formed by a polygonal bar.
Figure 5 is a schematic cross section view of the disc blade carrier carriage and of the support and travel rail therefor formed by a pair of parallel bars of right cylindrical section.
Figure 6 is a schematic cross section view of the disc blade carrier carriage and of the support and travel rail therefor formed by a circular section bar on which the carriage, further to being capable of sliding, is simultaneously capable of rocking.
Figure 7 is a schematic perspective view of a plate cutting apparatus having a sliding carriage corresponding to the type contemplated in Figure 5.

### Detailed Description of the Invention

As already said above, the known apparatus for cutting sheet-like articles are provided with a stationary rectilinear horizontal blade acting as counter blade for a moving disc blade, of which the disc blade is capable of rotation around a stub axle fixed to a carriage which is moveable along a horizontal rail. This moving disc blade bears with the plane of its cutting edge against the plane of the rectilinear stationary blade acting as counter blade and both are contained in one same vertical plane which is perpendicular to the flat surface of the sheet to be cut.

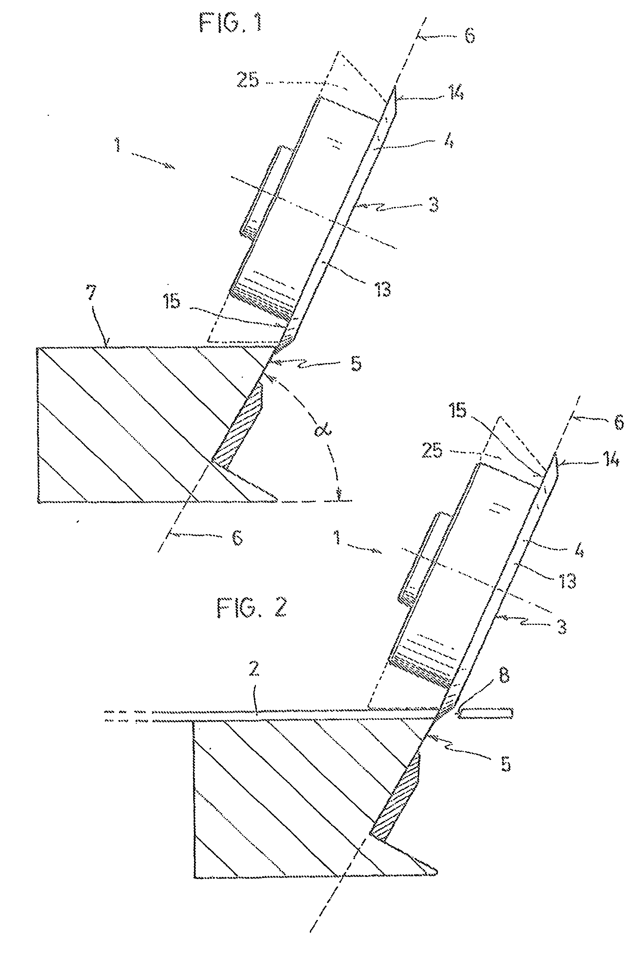

On the other hand, as shown in Figures 1 and 2, the members of the cutting system of the cutting apparatus 1 for the ends of photopolymer plate sheets 2 which, although they belong to the type of cutting devices for sheet-like articles working according to the scissors principle, have features which differentiate them essentially from the conventional ones, since the cutting apparatus 1 in question is formed by the association of a moving cutting member 3 having a disc blade 4 and a stationary rectilinear counter blade member 5 which are disposed permanently with partial successive mutual surfaces in sliding contact. Said surfaces are contained in a common virtual plane 6 which is permanently inclined at an acute angle α relative to the support surface 7 of the plate sheet 2 to be cut.

Figure 2 shows the immediate result of a cutting operation of a plate sheet 2 with the cutting apparatus 1, there being seen at the ends thereof a single bevel cut configuration 8, forming an acute dihedral angle β with a sharp apex 9, effected by the relative movement of the moving cutting member 3 having the disc blade 4 on the stationary counter blade member 5.

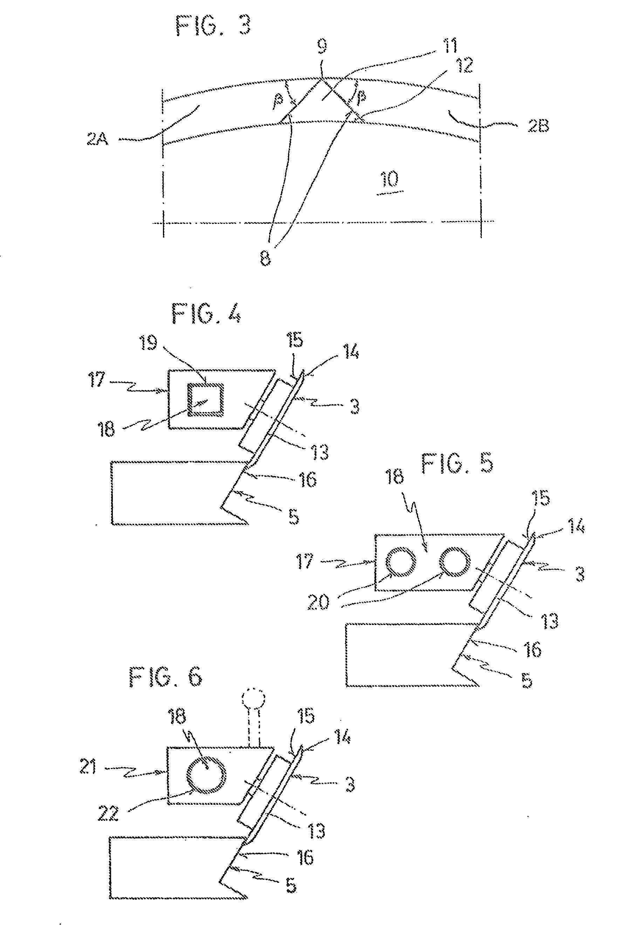

As may be seen in Figure 3, the cut plate sheet 2 has both opposite end sides 2A and 2B cut with single bevels 8 in opposite directions such that after the plate sheet 2 has been mounted to a roll 10 of the printing machine, they contact each other by the sharp apexes 9 of the acute dihedral angles β of their single bevels 8, forming a hollow space 11 of isosceles triangular section with an externally concave curved base 12.

Figures 4, 5 and 6 show how the moving cutting member 3 having the disc blade 4 consists of a rotating disc 13 having a perimetrical cutting edge 14 forming a single bevel 8 which is moveable in a straight line with one of the active faces thereof 15 contained in the common virtual plane 6 in which there is also contained the active face 16 of the stationary counter blade member 5 formed by the cantilevered beveled portion of the previous figures or by a rule insert contained, as in the previous case, in a plane inclined at an acute angle α relative to the support plane of the plate sheet 2 to be cut.

In the case shown in Figures 4 and 5, the moving cutting member 3 having the disc blade 4 is rotatably mounted on a carriage 17 which is slidingly unrotatably mounted on a rail 18 and is moveable therealong, such that the active face 15 of the rotating disc 13, forming the active member of the moving cutting member 3, is held in firm engagement with the active face 16 of the stationary counter blade member 5.

In these cases, the rail 18 is formed by a polygonal section bar 19 in Figure 4 and by a pair of parallelly disposed cylindrical bars 20 in Figure 5.

In the case of Figure 6, the moving cutting member 3 having the disc blade 4 is rotatably mounted on a sliding carriage 21 which is rockingly mounted on a rail 18, formed by a cylindrical bar 22, and is moveable therealong, such that the active face 15 of the rotating disc 13, forming the moving cutting member 3, is held engaged by gravity against the active face 16 of the stationary counter blade member 5.

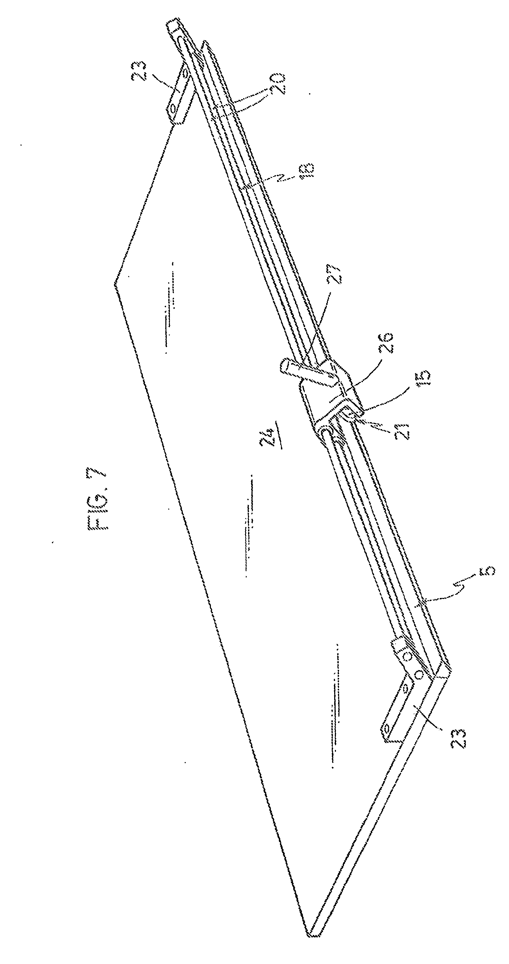

The plate cutting apparatus 1, as shown in Figure 7, is structured in such a way that the ends of the stationary counter blade member 5 and of the rail 18 are associated with respective stationary support bodies 23 therefor, which form the ends of a support body 24 for seating the plate sheets 2 into which are fitted the ends of said stationary counter blade member 5 and rail 18 formed by cylindrical bars 20, at the same time as, as the case may be, it supports a stationary counter blade member 5 in the form of a rule along the whole length thereof and holds the rail 8 in suspension with freedom of movement for the sliding carriage 21.

The rotating disc 15 of the moving cutting member 3 having the disc blade 4 is associated with a resilient pressure member 25, shown in Figures 1 and 2, which presses against the photopolymer plate sheet 2 and accompanies the rotating disc 15 in its stroke.

As shown in Figure 7, the moving cutting member 3 having the disc blade 4 mounted on the sliding carriage 21 will preferably be housed in a protective casing 26, which may be provided with a handle 27.

## Claims

1. An apparatus for cutting photopolymer plates, which comprises the association of a moving cutting member (3) having a disc blade (4) which is slidable along a rail (18) and a stationary rectilinear counter blade member (5) which is parallel to said rail (18), which are disposed permanently with partial successive mutual surfaces in sliding contact, which surfaces are contained in a common plane (6) sloping at an acute angle relative to the plane of the support surface (7) for the plate sheet (2) to be cut at the ends thereof, determining the value of the dihedral angle resulting from the single bevel cut (8) made at the edges of the plate sheet (2) by the relative movement of both members.

2. The plate cutting apparatus of claim 1, wherein the cut plate sheet (2) has both opposite end sides thereof cut as single bevels such that, having been made in opposite directions, after installation of the sheet on the roll (10) of a printing machine, said ends contact each other along the apexes of the acute dihedral angles of their single bevels, forming an isosceles triangular section hollow space having an externally concave base.

3. The plate cutting apparatus of claim 1, wherein the disc blade (4) of the moving cutting member (3) is formed by a rotating disc (13) having a single bevel perimetrical cutting edge (14), which is moveable in a straight line such that the active face of the faces thereof is contained in a virtual plane in which the active face of a stationary counter blade member is also contained, with the latter being formed by a rule contained on one face of an acute dihedral angle facing away from the plane of the support surface (7) for the plate sheet (2) to be cut.

4. The plate cutting apparatus of claim 3, wherein the moving cutting member (3) having a disc blade (4) is formed by a rotating disc (13) mounted on a sliding carriage (21) which, in turn, is rockingly mounted on a rail (18) and is moveable therealong, such that the active face of the rotating disc (13), forming the moving cutting member (3), is held engaged by gravity against the active face of the stationary counter blade member.

5. The plate cutting apparatus of claim 3, wherein the moving cutting member (3) having a disc blade (4) is rotatably mounted on a carriage (17) which is slidingly non-rotatably mounted on a rail (18) and is moveable therealong, such that the active face of the rotating disc (13), forming the moving cutting member (3), is held engaged firmly against the active face of the stationary counter blade member.

6. The plate cutting apparatus of claim 5, wherein the rail (18) is formed by a polygonal section bar.

7. The plate cutting apparatus of claim 5, wherein the rail (18) is formed by a pair of parallelly disposed cylindrical bars.

8. The plate cutting apparatus of claim 3, wherein the ends of the stationary counter blade member and of the rail (18) are associated with respective fixed support bodies (23) therefor fixedly attached to a support surface for the plate sheet (2).

9. The plate cutting apparatus of claim 3, wherein the two support bodies for the stationary counter blade member and the rail (18) form the ends of a support body in which the ends of said counter blade and rail (18) engage, at the same time as it supports the counter blade along the whole length thereof and holds the rail (18) suspended with freedom of movement for the sliding carriage (17).

10. The plate cutting apparatus of claim 3, wherein the rotating disc (13) of the moving cutting member (3) having a disc blade (4) is associated with a resilient pressure member (25) which presses on the plate sheet (2) and accompanies the rotating disc (13) along the stroke thereof.

11. The plate cutting apparatus of claim 3, wherein the moving cutting member (3) having a disc blade (4) mounted on the moving carriage is housed in a protective casing (26), which may be provided with a handle (27).

## Patentansprüche

1. Vorrichtung zum Schneiden von Photopolymertafeln, wobei die Vorrichtung das Verbinden eines beweglichen Schneidelements (3), das eine Scheibenklinge (4) umfasst, die entlang einer Schiene (18) verschiebbar ist, und eines stationären geradlinigen Gegenklingenelements (5), das parallel zu der Schiene (18) ist, wobei Elemente (3, 5) mit teilweise aufeinanderfolgenden gemeinsamen Flächen permanent in Schiebekontakt angeordnet sind, wobei die Flächen in einer gemeinsamen Ebene (6) liegen, die sich in einem spitzen Winkel relativ zu der Ebene der Unterstützungsfläche (7) neigt, damit die Tafel (2) an ihren Enden abgeschnitten werden kann, um **dadurch** den Wert des zweiflächigen Winkels zu bestimmen, der aus einem einzelnen Gehrungsschnitt (8), der an den Kanten der Tafel (2) durch Relativbewegung der beiden Elemente gemacht wird, resultiert.

2. Plattenschneidevorrichtung gemäß Anspruch 1, wobei die geschnittene Tafel (2) ihre beiden gegenüberliegenden Seiten als einzelne Schrägflächen geschnitten hat, derart, dass diese nach der Installation der Tafel auf der Rolle (10) einer Druckmaschine in entgegengesetzten Richtungen ausgeführt sind, wobei sich die Enden entlang der Spitzen der scharfkantigen zweiflächigen Winkel ihrer einzelnen Schrägflächen berühren, und wobei sie einen gleichschenkeligen dreieckigen Hohlraum ausbilden, der eine äußerte konkave Basis aufweist.

3. Plattenschneidevorrichtung gemäß Anspruch 1, wobei die Scheibenklinge (4) des beweglichen Schneidelements (3) durch eine rotierende Scheibe (13) ausgebildet wird, die eine einzelne umlaufende abgeschrägte Schneidkante (14) aufweist, die in einer geraden Linie beweglich ist, derart, dass die aktive Seite ihrer Flächen in einer gedachten Ebene liegt, in der auch die aktive Seite einer stationären Gegenklinge liegt, wobei letztere durch ein Lineal ausgebildet wird, das in einer Fläche eines spitzwinkeligen zweiflächigen Winkels enthalten ist, der von der Ebene der Unterstützungsfläche (7) für die zu schneidende Platte (2) wegweist.

4. Plattenschneidevorrichtung gemäß Anspruch 3, wobei das bewegliche Schneidelement (3) eine Scheibenklinge (4) aufweist, die durch eine rotierende Scheibe (13) ausgebildet wird, die an einer verschiebbaren Halterung (21) befestigt ist, die wiederum an einer Schiene (18) befestigt ist und entlang dieser Schiene bewegbar ist, derart, dass die aktive Seite der rotierenden Scheibe (13), die das bewegliche Schneidelement (3) ausbildet, durch Schwerkraft gegen die aktive Seite des stationären Gegenklingenelements in Eingriff gehalten wird.

5. Plattenschneidevorrichtung gemäß Anspruch 3, wobei das bewegliche Schneidelement (3) eine Scheibenklinge (4) aufweist, die drehbar an einer Halterung (17) befestigt ist, die nicht-drehbar beweglich an der Schiene (18) befestigt und entlang dieser bewegbar ist, derart, dass die aktive Seite der rotierenden Scheibe (13), die das bewegliche Schneidelement (3) ausbildet, in engem Eingriff gegen die aktive Seite des stationären Gegenklingenelements gehalten wird.

6. Plattenschneidevorrichtung gemäß Anspruch 5, wobei die Schiene (18) aus einer vielseitigen Profilstange ausgebildet ist.

7. Plattenschneidevorrichtung gemäß Anspruch 5, wobei die Schiene (18) durch ein Paar parallel angeordneter zylindrischer Stangen ausgebildet ist.

8. Plattenschneidevorrichtung gemäß Anspruch 3, wobei die Enden des stationären Gegenklingenelements und der Schiene (18) mit den entsprechenden festen Unterstützungskörpern (23) verbunden sind, die dafür fest an einer Unterstützungsfläche der Tafel (2) befestigt sind.

9. Plattenschneidevorrichtung gemäß Anspruch 3, wobei die zwei Unterstützungskörper für das stationäre Gegenklingenelement und die Schiene (18) die Enden eines Unterstützungskörpers ausbilden, in den die Enden der Gegenklinge und der Schiene (18) eingreifen, und zwar zur gleichen Zeit, wenn er die Gegenklinge entlang deren gesamten Länge stützt, und die Schiene (18) hält, deren Bewegungsfreiheit für die Schiebehalterung (17) gesperrt ist.

10. Plattenschneidevorrichtung gemäß Anspruch 3, wobei die rotierende Scheibe (13) des beweglichen Schneidelements (3), das eine Scheibenklinge (4) aufweist, mit einem elastischen Druckelement (25) verbunden ist, das auf die Platte (2) drückt und die rotierende Scheibe (13) entlang deren Hubes begleitet.

11. Plattenschneidevorrichtung gemäß Anspruch 3, wobei das bewegliche Schneidelement (3), das eine an der beweglichen Halterung befestigte Scheibenklinge (4) aufweist, in einem Schutzgehäuse (26) untergebracht ist, das mit einem Handgriff (27) ausgestattet werden kann.

## Revendications

1. Appareil pour couper des plaques photopolymères, qui comprend l'association d'un élément de coupe mobile (3), possédant une lame discoïde (4) qui peut coulisser le long d'un rail (18), et un élément contre-lame rectiligne stationnaire (5), qui est parallèle audit rail (18), qui sont disposés en permanence avec des surfaces mutuelles successives partielles en contact coulissant, lesquelles surfaces sont contenues dans un plan commun (6) incliné à un angle aigu par rapport au plan de la surface de support (7) pour la feuille en plaque (2) destinée à être coupée aux extrémités de celle-ci, déterminant la valeur de l'angle dièdre résultant de la coupe en biseau unique (8) réalisée aux bords de la feuille en plaque (2) par le mouvement relatif des deux éléments.

2. Appareil de découpe de plaques selon la revendication 1, dans lequel la feuille en plaque coupée (2) a les deux côtés d'extrémité opposés de celle-ci coupés sous forme de biseaux uniques de sorte que, ayant été réalisés dans des directions opposées, après l'installation de la feuille sur le rouleau (10) d'une machine à imprimer, lesdites extrémités entrent en contact l'une avec l'autre le long des sommets des angles dièdres aigus de leurs biseaux uniques, formant un espace creux de section triangulaire isocèle possédant une base concave extérieurement.

3. Appareil de découpe de plaques selon la revendication 1, dans lequel la lame discoïde (4) de l'élément de coupe mobile (3) est formée par un disque rotatif (13) possédant un bord de coupe périmétrique à biseau unique (14), qui est mobile dans une ligne droite de sorte que la face active des faces de celui-ci soit contenue dans un plan virtuel, dans lequel la face active d'un élément contre-lame stationnaire est également contenue, ce dernier étant formé par une règle contenue sur une face d'un angle dièdre aigu tourné dans une direction opposée au plan de la surface de support (7) pour la feuille en plaque (2) destinée à être coupée.

4. Appareil de découpe de plaques selon la revendication 3, dans lequel l'élément de coupe mobile (3) possédant une lame discoïde (4) est formé par un disque rotatif (13) monté sur un chariot coulissant (21) qui, à son tour, est monté de façon oscillante sur un rail (18) et est mobile le long de celui-ci, de sorte que la face active du disque rotatif (13), formant l'élément de coupe mobile (3), soit maintenue engagée par gravité contre la face active de l'élément contre-lame stationnaire.

5. Appareil de découpe de plaques selon la revendication 3, dans lequel l'élément de coupe mobile (3) possédant une lame discoïde (4) est monté de façon rotative sur un chariot (17) qui est monté de façon coulissante et de façon non rotative sur un rail (18) et est mobile le long de celui-ci, de sorte que la face active du disque rotatif (13), formant l'élément de coupe mobile (3), soit maintenue engagée fermement contre la face active de l'élément contre-lame stationnaire.

6. Appareil de découpe de plaques selon la revendication 5, dans lequel le rail (18) est formé par une barre à section polygonale.

7. Appareil de découpe de plaques selon la revendication 5, dans lequel le rail (18) est formé par une paire de barres cylindriques disposées parallèlement.

8. Appareil de découpe de plaques selon la revendication 3, dans lequel les extrémités de l'élément contre-lame stationnaire et du rail (18) sont associées à des corps de support fixes respectifs (23) pour ceux-ci, raccordés de façon fixe à une surface de support pour la feuille en plaque (2).

9. Appareil de découpe de plaques selon la revendication 3, dans lequel les deux corps de support pour l'élément contre-lame stationnaire et le rail (18) forment les extrémités d'un corps de support, dans lequel les extrémités de ladite contre-lame et dudit rail (18) s'engagent, en même temps qu'il supporte la contre-lame sur la longueur entière de celle-ci et retient le rail (18) suspendu avec une liberté de mouvement pour le chariot coulissant (17).

10. Appareil de découpe de plaques selon la revendication 3, dans lequel le disque rotatif (13) de l'élément de coupe mobile (3) possédant une lame discoïde (4) est associé à un élément de pression élastique (25) qui appuie sur la feuille en plaque (2) et accompagne le disque rotatif (13) le long de sa course.

11. Appareil de découpe de plaques selon la revendication 3, dans lequel l'élément de coupe mobile (3) possédant une lame discoïde (4) monté sur le chariot mobile est logé dans un carter de protection (26), qui peut être pourvu d'une poignée (27).
